# EUROPEAN PATENT APPLICATION

(11) **EP 2 175 496 A1**
(43) Date of publication of application: **14.04.2010**
(21) Application number: 07790269.0
(22) Date of filing: 18.07.2007
(51) Int. Cl.: H01L 31/04

(54) **SOLAR CELL**

(71) Applicant: Kyosemi Corporation, Kyoto-shi, Kyoto 612-8201 (JP)
(72) Inventor: NAKATA, Josuke, Kyoto-shi Kyoto 610-1102 (JP)
(74) Representative: Roberts, Mark Peter
(86) International application number: PCT/JP2007/000773
(87) International publication number: WO 2009/011013

(57) **Abstract**

A solar cell which is comprising a p⁺n⁺ junction composed of a pn junction capable of generating photovoltaic power on a p-type silicon monocrystal and an n⁺ diffusion layer and a p+ diffusion layer in which impurities are doped in a high concentration on a portion of the pn junction, has reverse conductivity properties for current flow through a p⁺n⁺ junction when a solar cell is biased in the reverse direction. In addition to preventing heat generation and deterioration of a solar cell when any of the solar cells enter shade, without connecting an external bypass diode, when a solar cell module is manufactured using a plurality of solar cells, a reduction in power generation efficiency in the entire solar cell module can also be prevented.

## Description

### TECHNICAL FIELD

The present invention relates to a solar cell, and more specifically relates to a solar cell having reverse conductivity properties in which current flows through the p+ n+ junction formed on a part of the pn junction when a solar cell is biased in the reverse direction.

### BACKGROUND TECHNOLOGY

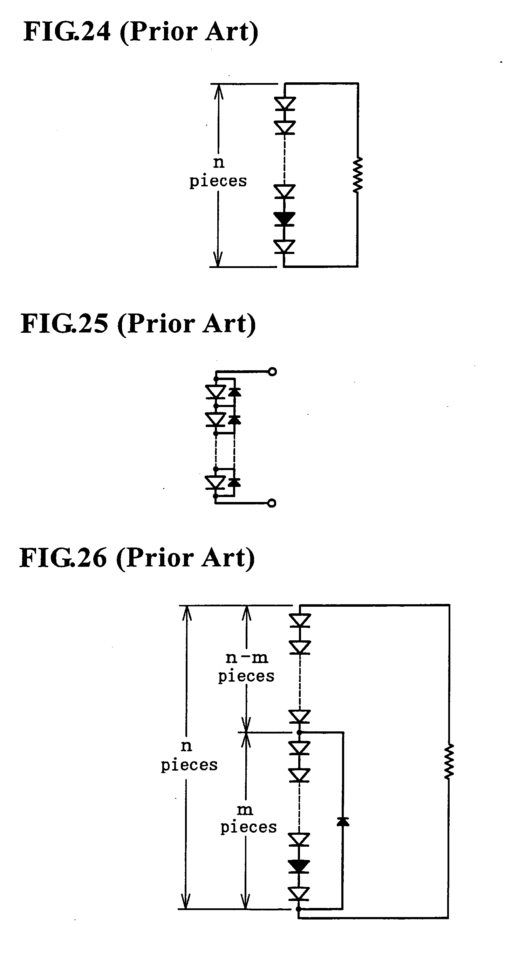

In general, a solar cell having a pn junction capable of generating photovoltaic power is used in a state which raises the maximum output voltage of photovoltaic power by serially connecting a plurality of solar cells since the maximum output voltage of photovoltaic power generated by one solar cell is low.
When any solar cell within a solar cell array serially connecting a plurality of solar cells enters shade and is unable to generate photovoltaic power as shown in Fig. 24, voltage equal to the sum of photovoltaic power generated by the other solar cells becomes biased in the reverse direction for that solar cell.

A solar cell may breakdown when the applied voltage exceeds the reverse direction withstanding voltage of that solar cell, but heat is generated by the solar cell even if the applied voltage is lower than the reverse direction withstanding voltage of the solar cell which may cause the solar cell itself or the surrounding materials to deteriorate.

Hence, as shown in Fig. 25, a structure to protect the solar cell can be conceived by arranging a single external bypass diode at each solar cell respectively connecting the bypass diodes in an inverse parallel manner to each solar cell thereby bypassing the current flowing to the solar cell when there is a reverse directional bias. However, equipping respective bypass diodes to every solar cell creates a complicated structure for the solar cell array which is costly to manufacture.

Therefore, as shown in Fig. 26, a structure is adopted in which a single bypass diode is connected in inverse parallel to each block composed from m number of solar cells for the solar cell array that serially connects n number of solar cells. In this case, when one solar cell within the block enters shade, the current flowing from the one or more other blocks, i.e. the current flow from (n-m) number of solar cells, does not flow to the other solar cells within the block including the solar cell that entered shade but flows through the bypass diode of that block.

Consequently, since power is not supplied to the load from this block even if other solar cells generate power in the block including the solar cell in the shade, the power generation efficiency of the solar cell array decreases because only power generated from (n-m) number of solar cells is supplied.
Additionally, the solar cell in the shade is biased in the reverse direction by the voltage drop that occurred due to the flow of current through the bypass diode in addition to the open circuit voltage of the remaining (m-1) number of solar cells, solar cells having a high withstanding voltage property able to withstand this are necessary.

In patent document 1, a description is given to an integrated solar cell that equips on the same silicon wafer, a pn junction as a solar cell and a shunt (bypass) diode that forms a pn junction to the reverse direction through this pn junction and an isolation region. Because the bypass diode is integrated with the solar cell, there is no need for an external bypass diode to be electrically connected to the solar cell.

The inventor of the present application discloses in patent document 2 a solar cell module that connects a plurality of spherical solar cells in parallel and in series. This solar cell module comprises spherical solar cells with aligned conductive direction arranged in a plurality of rows and columns in which adjacent solar cells are connected in parallel and in series. Therefore, if any of the solar cells enter shade, a reverse bias is not generated that exceeds the open circuit voltage of one solar cell as long as any of the solar cells within the solar cell module is generating power and a current path remains.
Patent Document 1: US Patent Publication No.4323719
Patent Document 2: PCT Application Publication No.WO2003/017382

### DISCLOSURE OF THE INVENTION

### PROBLEMS TO BE SOLVED BY THE INVENTION

However, since an inverse parallel pn junction is equipped through the isolation region and the pn junction of the solar cell in the solar cell described in patent document 1, space on the wafer that does not contribute to power generation is necessary leading to a larger structure. A further weakness is the drop in open circuit voltage due to the flow of current from the pn junction of the solar cell to the parasitic shunt resistance in the isolation region.

There is a tendency in the solar cell module described in patent document 2 for heat deterioration when any full row connected in parallel stops generating power due to shade because the total generated voltage of the other solar cells connected serially becomes biased in the reverse direction for that row to which the current path has disappeared causing damage to that row of solar cells. Therefore, such circumstances require the protection of the current path by equipping bypass diodes.

The object of the present invention is to provide a solar cell that has reverse conductivity properties for current flow when biased in the reverse direction without an electrical connection to an external bypass diode, and to provide a solar cell that is small in size and does not reduce power generation efficiency, and to provide a solar cell capable of decreasing manufacturing costs when manufacturing a solar cell module with these solar cells.

### MEANS TO SOLVE THE PROBLEM

The present invention relates to a solar cell equipped with a pn junction capable of generating photovoltaic power on a semiconductor substrate, comprising; a p⁺n⁺ junction comprising a p⁺ type conductive layer and an n⁺ type conductive layer in which impurities are doped in a high concentration on a portion of the pn junction, and a structure having a reverse conductivity characteristic for current flow through the p⁺n⁺ junction when the solar cell is biased in a reverse direction.

### ADVANTAGES OF THE INVENTION

According to the present invention, as there is provided a p⁺n⁺ junction comprising a p⁺ type conductive layer and an n⁺ type conductive layer in which impurities are doped in a high concentration on a portion of the pn junction, and a structure having a reverse conductivity characteristic for current flow through a p⁺n⁺ junction when the solar cell is biased in a reverse direction, the same advantages as inverse-parallel connecting a bypass diode to a solar cell can be achieved.

In other words, by manufacturing a solar cell module using these solar cells, heat deterioration of the solar cell can be prevented because the current flows through the p⁺n⁺ junction of the solar cell when any of the solar cells enter shade while also preventing reduction in the power generation efficiency of the entire solar cell module. Further, since there is no need to equip a bypass diode, structure can be smaller and manufacturing cost can be reduced.

The following various compositions may also be used in addition to the composition described above for the present invention.
(1) The pn junction is a pn⁺ junction or a p⁺n junction.
(2) The p⁺n⁺ junction has backward diode properties due to a tunneling effect.
(3) The p⁺n⁺ junction has properties of conducting at an equal or lower voltage than an open circuit voltage of the pn junction.

(4) The semiconductor substrate is formed spherically and comprising a substantially spherical surface shaped pn junction positioned at a constant depth from the surface of the semiconductor substrate, and comprising a pair of electrodes connected on both ends of the pn junction which are a pair of opposing electrodes interposing a center of the semiconductor substrate.
(5) The p⁺n⁺ junction is provided at a nearer portion to the semiconductor substrate side than one the electrodes within the peripheral vicinity of the one of the electrodes.
(6) The pn junction is formed through a n⁺ type conductive layer formed on a surface of the semiconductor substrate in which at least one part of the p⁺n⁺ junction is composed by a p⁺ type conductive layer formed on an inner surface of a semiconductor substrate side of one of the electrodes, and an n⁺ type conductive layer part that is contacted by the p⁺ type conductive layer.

(7) The electrode is formed so as to have a larger area than the p⁺n⁺ junction.
(8) At least one part of the p⁺n⁺ junction is composed by an n+ type conductive layer part that is coupled to the other electrode and a p⁺ type conductive layer that is coupled to the n⁺ type conductive layer part.
(9) The semiconductor substrate is formed in a cylindrical shape and which comprises a substantially cylindrical shaped pn junction in a position of constant depth from a surface of the semiconductor substrate.

(10) The p⁺ type conductive layer formed on the inner surface of one of the electrodes is formed by way of a recrystallized layer that is formed by an eutectic reaction of the semiconductor substrate with the other metallic electrode.
(11) The semiconductor substrate is formed to be a flat-shaped substrate; and the pn junction is formed on a near area of one surface of a solar light incidence side of the semiconductor substrate; and a grid shaped electrode is provided on a reverse surface to the one surface of the semiconductor substrate; and light receiving windows, which are not shielded by the grid shaped electrode, are formed on the one surface of the semiconductor substrate; and a high density conductive layer is formed in which impurities are doped in a high concentration with the same electric conductive type as the semiconductor substrate on all surfaces that do not face the light receiving windows on the semiconductor substrate; and the p⁺n⁺ junction is formed through the high density conductive layer on a rear surface side part of the grid shaped electrode on the one surface of the semiconductor substrate..

### BRIEF EXPLANATION OF THE DRAWINGS

Fig. 1 is a cross sectional view of a spherically shaped p-type silicon monocrystal having a flat surface in Embodiment 1.
Fig. 2 is a cross-sectional view of a p-type silicon monocrystal having a p⁺ diffusion layer.
Fig. 3 is a cross-sectional view of a p-type silicon monocrystal having an n⁺ diffusion layer, pn⁺ junction, and p⁺n⁺ junction.
Fig. 4 is a cross-sectional view of a solar cell.
Fig. 5 is an enlarged cross-sectional view of the main section of a solar cell.
Fig. 6 is a diagram showing the equivalent circuit of a solar cell.
Fig. 7 is an explanatory drawing showing an energy band (thermal equilibrium state) of a p⁺n⁺ junction.
Fig. 8 is an explanatory drawing showing an energy band (reverse bias state) of a p⁺n⁺ junction.
Fig. 9 is drawing showing the voltage and current properties of a conventional solar cell and a solar cell of the present invention.
Fig. 10 is a diagram showing an energy band of a solar cell having a BSF structure.
Fig. 11 is a diagram showing the equivalent circuit of a solar cell module having a plurality of solar cells.
Fig. 12 is a cross-sectional view of a p-type silicon monocrystal having a flat surface in Embodiment 2.
Fig. 13 is a cross-sectional view of a p-type silicon monocrystal having a p⁺ diffusion layer.
Fig. 14 is a cross-sectional view of a p-type silicon monocrystal having an n⁺ diffusion layer, pn⁺ junction, and p⁺n⁺ junction.
Fig. 15 is a cross-sectional view of a solar cell and a lead frame.
Fig. 16 is an enlarged cross-sectional view of the main section of a solar cell and a lead frame.
Fig. 17 is a plan view of a p-type silicon monocrystal wafer having a p⁺ diffusion layer in Embodiment 3.
Fig. 18 is a cross-sectional view along the line XVIII-XVIII of Fig. 17.
Fig. 19 is a plan view of a solar cell in Embodiment 3.
Fig. 20 is a cross-sectional view of a solar cell in Embodiment 3.
Fig. 21 is a perspective view of a solar cell in Embodiment 4.
Fig. 22 is a cross-sectional view along the line XXII-XXII of Fig. 21.
Fig. 23 is an enlarged cross-sectional view of the main section of a solar cell.
Fig. 24 is a diagram of a solar array circuit in which n number of solar cells are serially connected in accordance with the prior art.
Fig. 25 is a diagram of a solar array circuit in which one bypass diode is connected in inverse-parallel for every solar cell in accordance with the prior art.
Fig. 26 is a diagram of a solar array circuit in which one bypass diode is connected in inverse-parallel for every block in accordance with the prior art.

### DESCRIPTION OF NUMERALS

- 1, 12, 31, 51: solar cell
- 2, 13, 52: p-type silicon monocrystal
- 4, 15, 34, 54: p⁺ diffusion layer
- 5, 16, 35, 55: n⁺ diffusion layer
- 6, 17, 36, 56: pn⁺ junction
- 7, 18, 21, 37, 57: p⁺n⁺ junction
- 8, 19, 38, 58: positive electrode
- 9, 22, 39, 59: negative electrode
- 20: p⁺ silicon recrystallized layer
- 32: p-type silicon monocrystal wafer
- 33: light receiving window

### BEST MODE FOR IMPLEMENTING THE INVENTION

The best mode for carrying out the invention will be described hereinafter with reference to drawings.

### EMBODIMENT 1

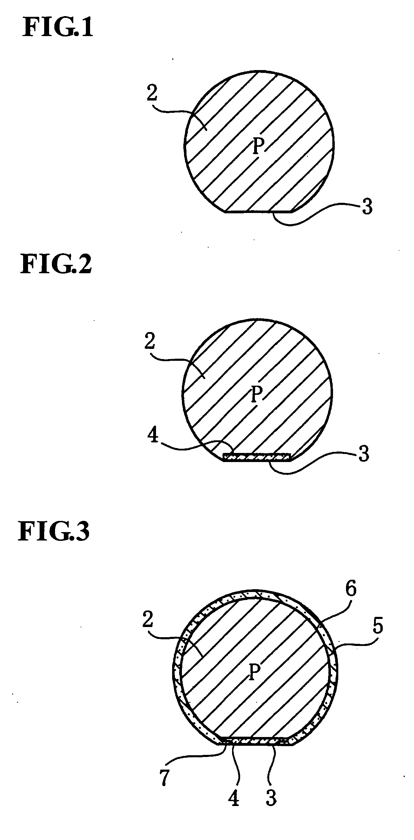

A description will be given regarding solar cell 1 according to Embodiment 1 based on Fig. 1 to Fig. 5.
Spherical solar cell 1 is formed with p⁺n⁺ junction 7 composed of a p⁺ diffusion layer 4 and an n⁺ diffusion layer 5 in which impurities are doped in a high concentration on a part of pn⁺ junction 6 formed in a spherical p-type silicon monocrystal 2.

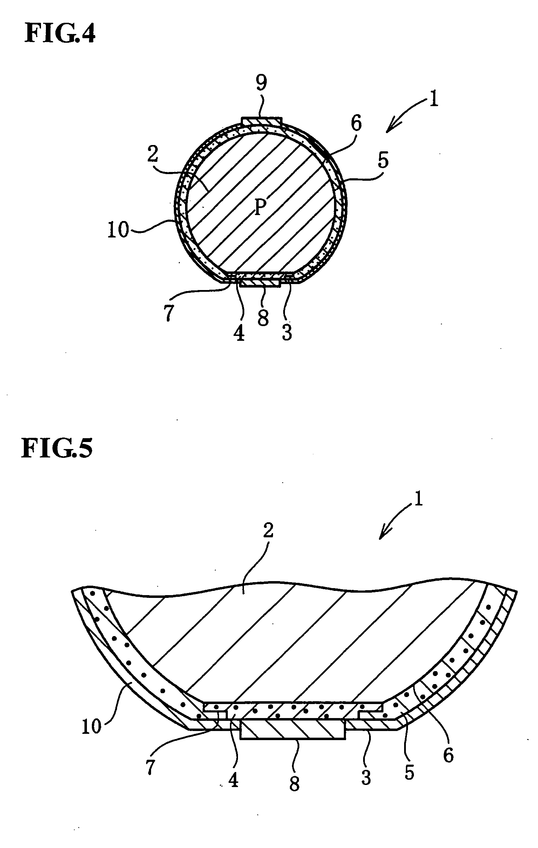

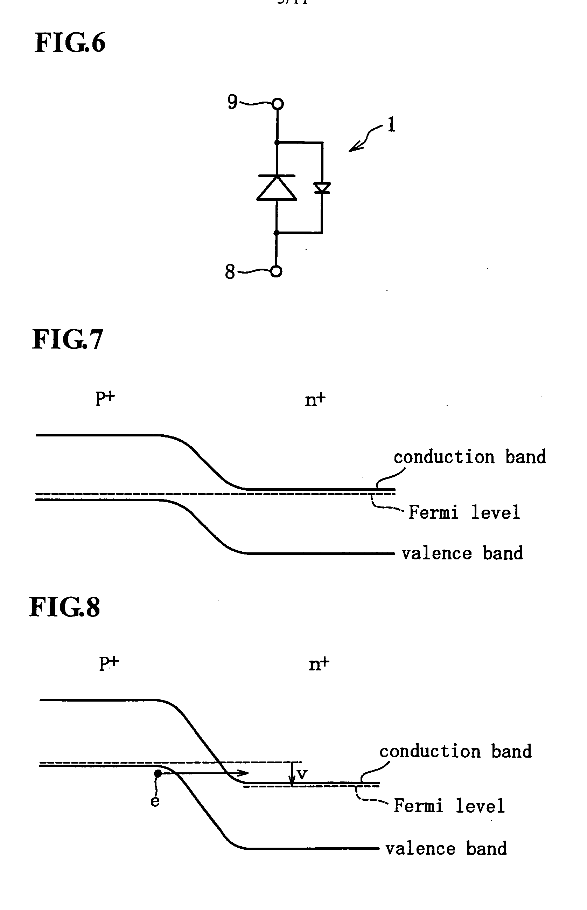

A description will be given first regarding the constitution of the solar cell 1. As shown in Fig. 4 and Fig. 5, solar cell 1 comprises a spherical p-type silicon monocrystal 2 (this corresponds to the semiconductor substrate), a flat surface 3 formed at one end of the silicon monocrystal 2, an n⁺ diffusion layer 5 (this corresponds to the n⁺ conductive layer) formed on the surface of the silicon monocrystal 2 except for the flat surface 3, a pair of opposing electrodes 8, 9 interposing the center of the silicon monocrystal 2, a p⁺ diffusion layer 4 (this corresponds to the p⁺ conductive layer) formed on the inner surface of the silicon monocrystal 2 side of the positive electrode 8, and an anti-reflection film 10 that covers the portions other than the positive electrode 8 and negative electrode 9 within the surface of the solar cell 1. In addition, the positive electrode 8 is equipped on the flat surface 3.
The pn⁺ junction 6 that functions as the pn junction capable of generating photovoltaic power, is formed on the surface of the silicon monocrystal 2, and this pn⁺ junction 6 is formed in a substantially spherical shape in a position at a constant depth from the surface of the silicon monocrystal 2 except for the flat surface 3. A pair of spot-shaped electrodes 8, 9 is connected to both ends of pn⁺ junction 6. The p⁺n⁺ junction 7 is formed in a ring shape and having backward diode properties due to a tunneling effect, at a nearer portion to the silicon monocrystal 2 side portion than the positive electrode 8 within the peripheral vicinity of the positive electrode 8, and an equivalent circuit of the solar cell 1 is shown in Fig. 6. Further, the positive electrode 8 is formed in a larger area than the p⁺n⁺ junction 7.

Next, a description will be given regarding a manufacturing method of the solar cell 1.
As shown in Fig. 1, in step 1, the flat surface 3 of 0.8 mm in diameter is formed at the bottom end of the spherical p-type silicon monocrystal 2 (approximately 1Ω cm of resistivity) as the semiconductor substrate of 1.8 mm diameter, and the flat surface 3 is used for positioning the silicon monocrystal 2 in subsequent steps as the reference plane. In step 2, after a SiO₂ film masks everything except the flat surface 3 of the silicon monocrystal 2, thermal diffusion is performed with boron, and the p⁺ diffusion layer 4 having a thin disc-like high impurity concentration ((1∼3) x 10²⁰ cm⁻³) with approximately 1µm of thickness is formed on the inner surface of the flat surface 3 as shown in Fig. 2.

As shown in Fig. 3, in step 3, after the SiO₂ is formed on the entire spherical body surface of the silicon monocrystal 2 including the p⁺ diffusion layer 4, the SiO₂ film is removed by etching so that the SiO₂ film can remain as a mask on the center area of the flat surface 3 that is slightly smaller than the diameter of the p⁺ diffusion layer 4, and thermal diffusion is performed with phosphorous, and then, the n⁺ diffusion layer 5 in a nearly spherical shape having high impurity concentration ((4 ∼ 6) x 10²⁰ cm⁻³) with approximately 0.5µm of the thickness is formed at the periphery of the flat surface 3 and the spherical surface area. As a result, the ring-shaped p⁺n⁺ junction 7 adjacent to the pn⁺ junction 6 is formed at the periphery of the p⁺ diffusion layer 4 on the flat surface 3. Subsequently, surface blemishes caused by the formation of the high impurity concentration layer are eliminated by removing only about 0.1 to 0.2µm of the surface of the n⁺ diffusion layer 5 by etching.

As shown in Fig. 4 and Fig. 5, in step 4, after the anti-reflection film 10 (for instance, SiO₂ film) is formed across the entirety at a thickness of approximately 1∼2 µm, thermal treatment is performed after applying resin paste containing aluminum to the center area of the p⁺ diffusion layer 4 of the flat surface 3 and also applying resin paste containing silver to the top of the spherical surface of the n⁺ diffusion layer 5, then positive electrode 8 which has a low resistance contact with the p⁺ diffusion layer 4 and negative electrode 9 which has a low resistance contact with the n⁺ diffusion layer 5 are formed. The diameters of electrodes 8, 9 are preferably between 0.4 and 0.6mm. As a result, an electric circuit via the pn⁺ junction 6 and an electric circuit via the p⁺n⁺ junction 7 are formed respectively between the positive electrode 8 and the negative electrode 9, and thus, a spherical solar cell 1 having reverse conducting properties is completed.

Next, a description regarding the reverse conducting properties held by the solar cell 1 will be explained.
Fig. 7 and Fig. 8 are diagrams showing the energy band of the p⁺n⁺ junction 7, and Fig. 7 shows the thermal equilibrium state and Fig. 8 shows the reverse bias state respectively.
As shown in Fig. 7, the Fermi level in the thermal equilibrium state of the p⁺n⁺ junction 7 is the same level across both regions from p⁺ region through n⁺ region. The level is just over the valence band for the p⁺ region, and just underneath of the conduction band for the n⁺ region, and furthermore, the width of the transition region for the p⁺n⁺ junction 7 is designed to be extremely thin.

When reverse bias voltage V in which the p⁺ side is minus and the n⁺ side is plus is impressed as shown in Fig. 8, the potential difference between the p⁺ region and the n⁺ region becomes larger, the width of the transition region of the p⁺n⁺ junction 7 becomes thinner, the electron e of the valence band of the p⁺ region permeates the transition region due to the tunneling effect and is directly transmitted to the conductive band of the n⁺ region, and thus an electric current flows. In other words, current flows through the p⁺n⁺ junction 7 when the solar cell 1 is biased in the reverse direction because the p⁺n⁺ junction 7 has backward diode properties due to the tunneling effect.

Next, a description will be given regarding the voltage/current properties and the action and advantages of the solar cell 1.

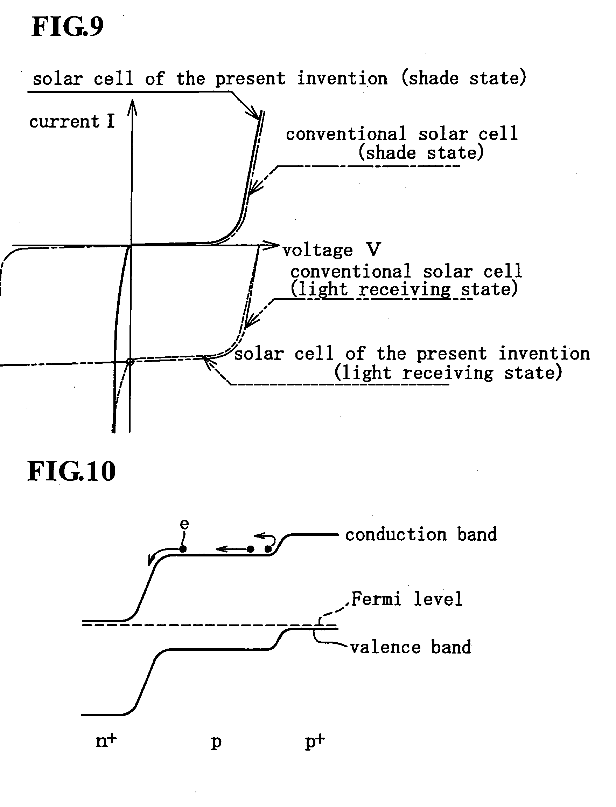

Fig. 9 is a diagram showing voltage/current properties of a conventional ordinary solar cell and the solar cell 1 of the present invention. As shown by the solid line and dashed line in Fig. 9, in the state where the solar light is blocked (state of entering shade), the forward voltage/current properties of both solar cells show an abrupt increase in electrical current when a predetermined threshold voltage is exceeded. In reverse voltage/current properties, the conventional solar cell shows the properties of entering the breakdown region in which current increases rapidly from a predetermined voltage through a region having poor electrical current flow; however, the solar cell 1 of the present invention is made so as to directly enter the conductive region with no region for blocking current flow because the p⁺n⁺ junction 7 has backward diode properties due to the tunneling effect.

On the other hand, in the state where solar light is received, as shown by the dotted line and a two-dot chain line in the fourth quadrant of Fig. 9, the solar cell 1 of the present invention generates photovoltaic power in a similar manner to the conventional solar cell due to having output voltage/current properties that are similar to the conventional solar cell.
Thus, the solar cell 1 of the present invention generates photovoltaic power in the same manner as a conventional solar cell when solar light is received; but when solar cell 1 enters shade and is biased in the reverse direction, circumstances which can cause the solar cell 1 to break due to reverse voltage, and deterioration in the solar cell 1 itself or in its peripheral components due to heat can be avoided because the pn⁺ junction 6, that is the photovoltaic power generating section between the positive electrode 8 and negative electrode 9, and the p⁺n⁺ junction 7, which has the backward diode properties, are connected in parallel and because reverse conducting properties are provided in which electrical current flows through the p⁺n⁺ junction 7.

In the case where solar cells 1 are used by connecting in a series, when some of the solar cells 1 enter shade and stop generating photovoltaic power, it is possible to keep feeding the output to the load without waste by automatically switching the current path to the p⁺n⁺ junction 7 area instantly and passing the output current of the other power generating cells in low resistance. Because the solar cells 1 have reverse conducting properties, there is no need to connect to an external bypass diode as in the past thereby reducing the size of the structure and allowing manufacturing costs to be reduced.

Further, as a result of having a spherical pn⁺ junction 6, a constant solar light receiving surface can be secured even when the angle of incidence of direct sunlight changes, and it is possible to make use of the surrounding reflected light due to the wide directivity for receiving sunlight. Because p⁺n⁺ junction 7 appears on the surface without the edge of pn⁺ junction 6 appearing on the surface of the p-type silicon monocrystal 2 that includes the n⁺ diffusion layer 5, recombination current is decreased on the surface of the p-type silicon monocrystal 2 that includes the n⁺ diffusion layer 5, and this contributes to the improvement of open voltage and short circuit currents of solar cell 1.

Furthermore, the p⁺ diffusion layer 4, with a low resistance contact with positive electrode 8, has a high electron energy level in relation to the p-type region as shown in Fig.10, and the BSF (back surface field) effect which repels electrons e generated by light excitation is induced, and thus, enhancing open voltage and short circuit currents is possible. As a result of providing spot-shaped positive electrode 8 and negative electrode 9 interposing the center of the p-type silicon monocrystal 2, the generation of electricity is possible by receiving incident light on surfaces other than electrodes 8, 9 within solar cell 1 thereby enabling power generation efficiency to be highly maintained. Moreover, heat waves with long wavelengths that cannot be absorbed by silicon easily pass through solar cell 1 thereby lowering the rise in temperature of solar cell 1.

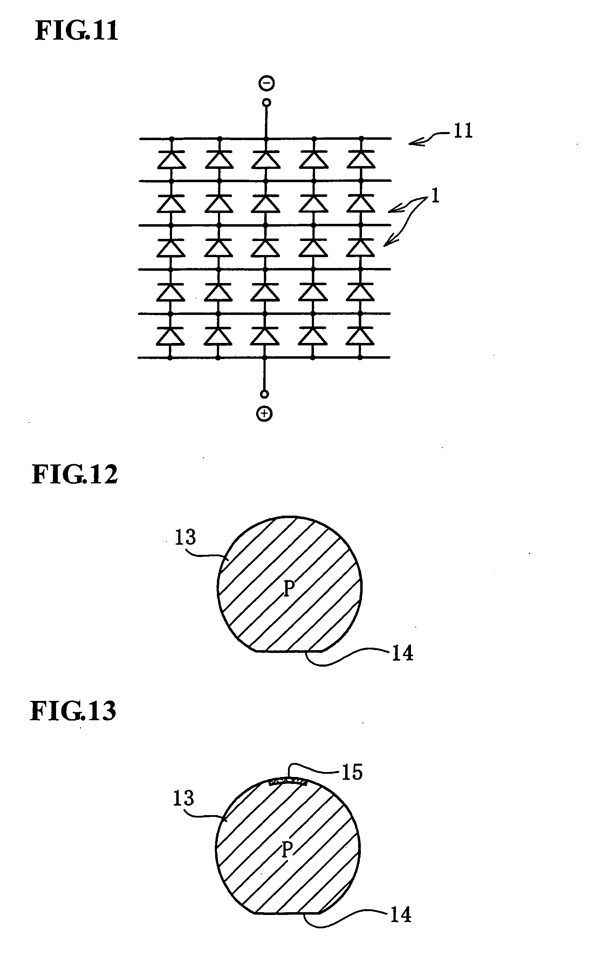

Next, a description regarding actions and advantages of solar cell module 11 having a plurality of solar cells 1 will be given. In the solar cell module 11 as shown in Fig. 11, for example, 25 pieces of solar cell 1 are arranged in 5 columns and 5 rows with a uniform conductive direction, a plurality of solar cells 1 in each column are electrically connected in a series, a plurality of solar cells 1 in each row is electrically connected in parallel, and 25 pieces of solar cell 1 are electrically connected by a mesh patterned series-parallel circuit. In addition, the illustration of bypass diodes built-in to each solar cell 1 is omitted in Fig. 11.

In solar cell module 11, even if all of the solar cells 1 of a single row within a plurality of rows that are connected in parallel enter shade, the bypass current flows by passing through the p⁺n⁺ junction 7 of the solar cells of that row. Therefore, in the solar cell module 11 composed by electrically connecting a plurality of solar cells 1 in a mesh patterned series-parallel circuit, even though shade of any pattern occurs, generated power can be drawn without loss, and there is no risk of harmful effects on the individual solar cells 1. In addition, the flat surface 3 formed on solar cell 1 is not essential and can be omissible.

### EMBODIMENT 2

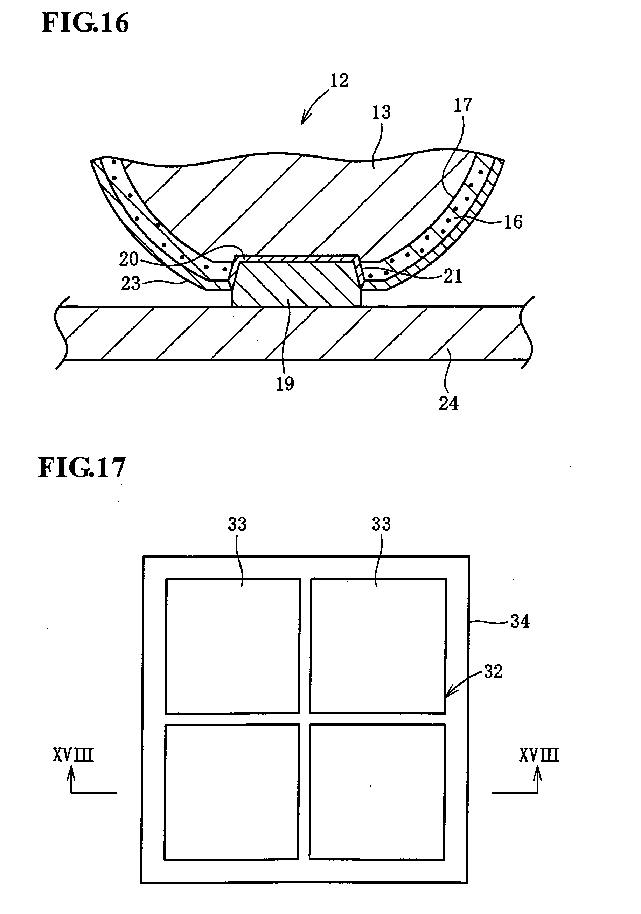

A description will be given for solar cell 12 of Embodiment 2.
The spherical solar cell 12 of embodiment 2, as shown in Fig. 12 ∼ Fig. 16, is provided with a p⁺n⁺ junction 18 and a p⁺ diffusion layer 15 in a position parallel to negative electrode 22 as well as hidden by negative electrode 22, and the p⁺ silicon recrystallized layer 20 is formed by the eutectic reaction of a p-type silicon monocrystal 13 with positive electrode 19 made of the aluminum alloy.

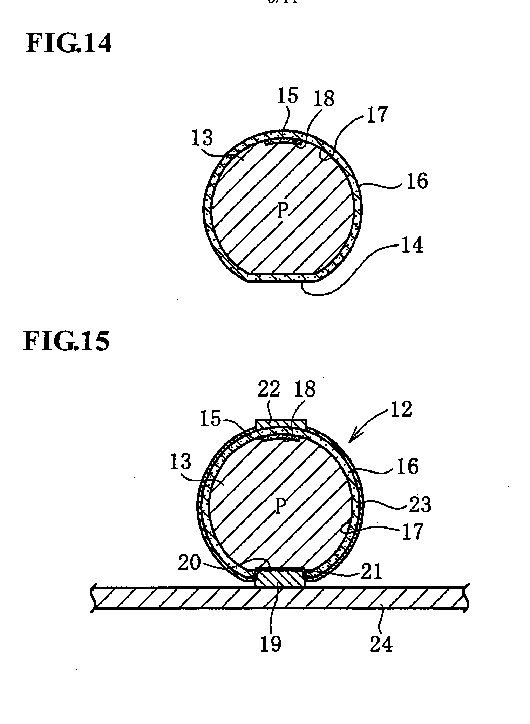

A description will be given first regarding the constitution of the solar cell 12.
As shown in Fig. 15 and Fig. 16, solar cell 12 comprises a spherical p-type silicon monocrystal 13, an n⁺ diffusion layer 16 formed on the surface area of the p-type silicon monocrystal 13, a pair of opposing electrodes 19, 22 interposing the center of the p-type silicon monocrystal 13, a p⁺ diffusion layer 15 formed on the surface area of the p-type silicon monocrystal 13 on the inner side of the negative electrode 22, a p⁺ silicon recrystallized layer 20 formed on the surface of the p-type silicon monocrystal 13 on the inner side of the positive electrode 19, and an anti-reflection film 23 that covers the portions other than the positive electrode 19 and negative electrode 22 within the surface of the solar cell 12.

A circular p⁺n⁺ junction 18 is composed of the portion of the n⁺ diffusion layer 16 connected to the negative electrode 22, and the portion of the p⁺ diffusion layer 15 connected to the n⁺ diffusion layer 16; and a ring-shaped p⁺n⁺ junction 21 is composed of the p⁺ silicon recrystallized layer 20 of the inner surface of the p-type silicon monocrystal 13 on the inner side of the positive electrode 19, and the portion of the n⁺ diffusion layer 16 where the p⁺ silicon recrystallized layer 20 makes contacts.

Next, a description will be given regarding the manufacturing method of the solar cell 12.
As shown in Fig. 12, in step 1, a flat surface 14 of 0.8 mm in diameter is formed at the p-type silicon monocrystal 13 of 1.8 mm diameter with approximately 1Ω cm of resistivity as the semiconductor substrate in the same manner as step 1 in Embodiment 1.
In step 2, after making the SiO₂ film masking almost all area except the area of approximately 0.4mm in diameter on the top of the p-type silicon monocrystal 13, thermal diffusion is performed with boron, and the p⁺ diffusion layer 15 having a high impurity concentration ((1∼3) x 10²⁰ cm⁻³) with approximately 1µm of thickness is formed as shown in Fig. 13.

As shown in Fig. 14, in step 3, an n⁺ diffusion layer 16 having a high impurity concentration ((4 ∼ 5) x 10²⁰ cm⁻³) with approximately 0.5µm of the thickness is formed on the entire spherical surface of the p-type silicon monocrystal 13 by performing thermal diffusion with phosphorous on the entire surface of the p-type silicon monocrystal 13. As a result, a p⁺n⁺ junction 18 is formed on the surface of the p-type silicon monocrystal 13 on the top of the n⁺ diffusion layer 16 and the pn⁺ junction 17. Subsequently, surface blemishes caused by the formation of the high impurity concentration layer are eliminated by removing only about 0.1 to 0.2µm of the surface of the n⁺ diffusion layer 16 by etching.

As shown in Fig. 15, in step 4, the spherical body obtained in step 3 is placed, for example, on a lead frame 24 made of iron-nickel alloy (iron 58%, nickel 42%) with 0.9mm in width and 0.2mm in thickness and securely attached by an aluminum alloy. More specifically, it is inserted in the state where discs (for example, 0.6mm in diameter, 0.1mm in thickness) made of aluminum alloy (containing boron 0.1% and approximately 0.2% of silicon) that mutually overlap, between the spherical flat surface 14 and the lead frame 24, and aluminum alloy and silicon have an eutectic reaction by heating rapidly up to about 830 °C in a vacuum or inert gas with immediate and rapid cooling thereafter.

The p⁺ silicon recrystallized layer 20 passes through the portion of the n⁺ diffusion layer 16 of the flat surface 14 and is formed by the eutectic reaction between aluminum alloy and silicon, and a portion of the peripheral side of the positive electrode 19 in the p⁺ silicon recrystallized layer 20 makes contact with the n⁺ diffusion layer 16 thereby forming a ring-shaped p⁺n⁺ junction 21. The p⁺ silicon recrystallized layer 20 contains boron and aluminum in high concentration as impurities, and the alloy area composed of aluminum and silicon is securely attached to the lead frame 24 thereby becoming the positive electrode 19. In addition, in step 4, the negative electrode 22 is also simultaneously formed with the formation of the positive electrode 19 by applying dot-shaped silver paste containing approximately 0.5% of antimony on the surface of the top of the n⁺ diffusion layer 16 in advance in order to form the negative electrode 22. Subsequently, an anti-reflection film 23 with the prescribed thickness is formed on the surfaces other than electrodes 19, 22 of the solar cell 12 by a known sputtering method.

The solar cell 12 can perform the above operations by placing a large number of solar cells 12 simultaneously on the lead frame 24 although there is no illustration, and thereafter, a module can be manufactured by connecting the top of the negative electrode 22 in parallel with the lead frame. Further, the voltage/current properties of the solar cell 12 are nearly the same as the case in Embodiment 1.

In this manner, the solar cell 12 has a large capacity for reverse current because the area of the p+n+ junction 18, 21 is larger than that of the solar cell 1 of embodiment 1; and the protection performance for the solar cell 12 when biased in the reverse direction is significantly greater. Space for the photovoltaic region is not sacrificed because the p⁺n⁺ junction 18 is provided in a position parallel to negative electrode 22 as well as hidden by negative electrode 22 efficiently using the region shielded to the incident light due to the negative electrode 22. Serial resistance at the time of reverse conductivity is reduced because the ring-shaped p⁺n⁺ junction 21 is provided in a position facing the outer surface of the positive electrode 19. Finally, the manufacturing process is simplified and the manufacturing cost is reduced because the formation of the p⁺ silicon recrystallized layer, the formation of the positive electrode 19, and the connection with the lead frame 24 are performed at the same time. In addition, the flat surface 14 formed on solar cell 12 is not essential and can be omissible.

### EMBODIMENT 3

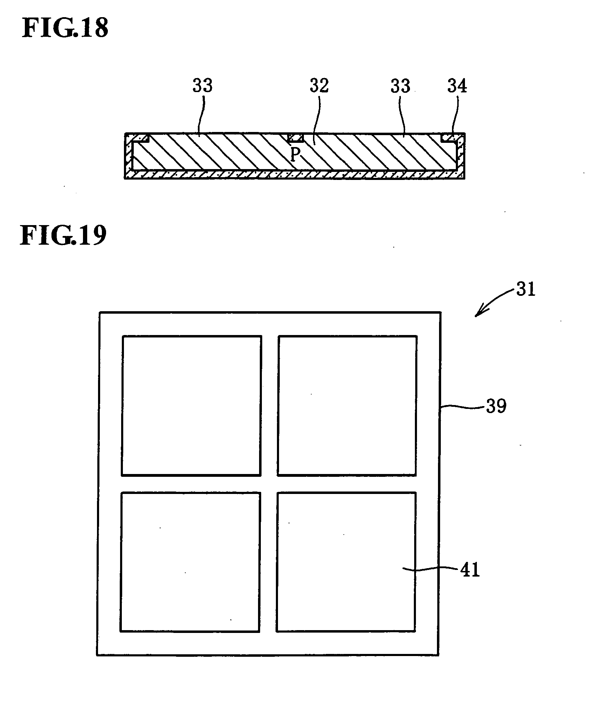

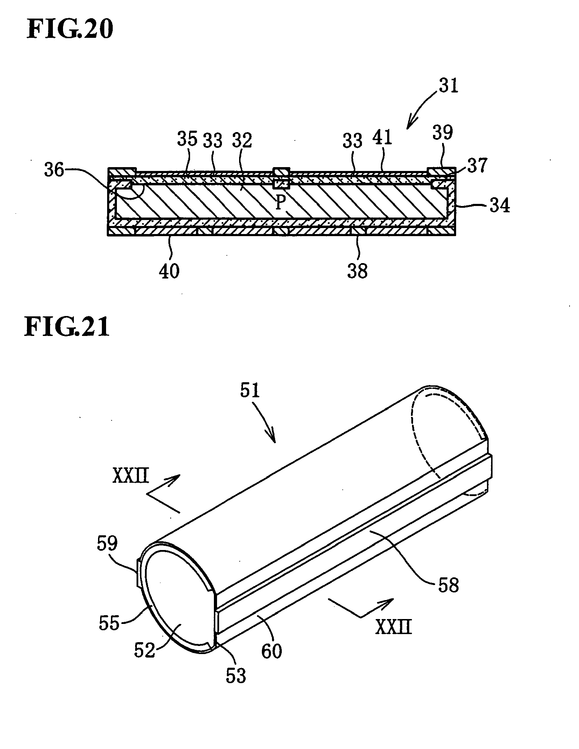

Next, a description will be given based on Fig. 17 ∼ Fig. 20 of the solar cell 31 of embodiment 3.
As shown in Fig. 19 and Fig. 20, the flat solar cell 31 forms the pn⁺ junction 36 in the vicinity of one side on the solar light incidence side of the flat p-type silicon monocrystal wafer 32 while forming the p⁺n⁺ junction 37 through the p⁺ diffusion layer 34 at the rear surface part of the negative electrode 39.

A description will be given first regarding the constitution of the solar cell 31.
As shown in Fig. 19 and Fig. 20, the solar cell 31 comprises a flat shaped p-type silicon monocrystal wafer 32; a grid shaped positive electrode 38 formed on the reverse surface of the silicon monocrystal wafer 32 and a grid shaped negative electrode 39 formed on one side on the solar light incidence side of the silicon monocrystal wafer 32; a light receiving window 33, which is not shielded by the negative electrode 39, formed on one surface of the silicon monocrystal wafer 32; a p⁺ diffusion layer 34 formed on all surfaces except the light receiving windows 33 on the silicon monocrystal wafer 32; an n⁺ diffusion layer 35 formed on the surface of the one side of the silicon monocrystal wafer 32; an anti-reflection film 41 that covers the surface of the light receiving windows 33; and an underside reflective coating 40 covering the parts other than the positive electrode 38 on the surface of the reverse side. The pn⁺ junction 36 is formed in the vicinity of one side of the silicon monocrystal wafer 32, and the p⁺n⁺ junction 37 is formed through the p⁺ diffusion layer 34 on the rear surface side of the cathode 39 of the one side.

A description will follow of the manufacturing method of the solar cell 31. In step 1, the p-type silicon monocrystal wafer 32 with a 1Ω resistivity is prepared first as the semiconductor substrate. The silicon monocrystal wafer 32 is formed in a flat shape in a predetermined size (for instance 2 cm x 2 cm) with a thickness of 0.25 mm, and various sizes can also be applied.

Next, in step 2 as shown in Fig. 17 and Fig. 18, the silicon monocrystal wafer 32 is masked with silicon oxide film and thermal diffusion is selectively performed with boron forming the grid shaped p⁺ diffusion layer 34 having a high concentration of impurities ((1∼3) x10²⁰cm⁻³) of 0.5 ∼ 1µm thickness. Four square light receiving windows 33 are formed on the surface of the solar light incidence side of the silicon monocrystal wafer 32, and the portion other than light receiving windows 33 of the surface of the solar light incidence side is covered with boron thermal diffused p⁺ diffusion layer 34.

As shown in Fig. 19 and Fig. 20, in step 3, phosphorous thermal diffusion is performed only on the surface of the solar light incidence side of the silicon monocrystal wafer 32 forming the n⁺ diffusion layer 35 having a high concentration of impurities ((4∼5) x10²⁰cm⁻³) of 0.4 ∼ 0.5 µm thickness. In this way, the pn⁺ junction 36 is formed in the vicinity of one side of the silicon monocrystal wafer 32 together with the formation of the grid shaped p⁺n⁺ junction 37. In addition, the edge of the pn⁺ junction 36 contacts the p⁺n⁺ junction 37 but does not contact the outer surface of the silicon monocrystal wafer 32 including the n⁺ diffusion layer 35.

Next, in step 4, deposition of a dot shaped metallic film and heat treatment forms the low resistance contact positive electrode 38 on the surface of the p⁺ diffusion layer 34 on the reverse side surface of the silicon monocrystal wafer 32, and the underside reflective coating 40 is formed, consisting of silicon oxide to reflect light entering from the outside toward the interior, on the parts other than the positive electrode 38 on the surface of the p⁺ diffusion layer 34 is formed on the reverse side surface. Further, deposition of a grid shaped metallic film and heat treatment forms the low resistance contact negative electrode 39 on the surface of the n⁺ diffusion layer 35. The grid width of the negative electrode 39 is formed slightly larger than the grid width of the p⁺ diffusion layer 34. The anti-reflection film 41 is formed next consisting of silicon oxide film, or so forth, on the surface of the light receiving windows 33 thereby completing the flat solar cell 31 having reverse conductivity properties.

In this manner, solar cell 31 has a repelling BSF effect around its entire surroundings so as not to lose electrons with the surface or the electrode interface, generated by photo excitation within the silicon, because the entire surface of the silicon monocrystal wafer 32 is covered by the p⁺ diffusion layer 34 except for the light receiving windows 33.
As a result, open circuit voltage and short circuit current can be improved. In addition, the effective light receiving surface area of the solar cell 31 can be implemented without reduction because the p⁺n⁺ junction 37 is formed on the portion of the rear surface side of the negative electrode 39 that cannot receive light.

### EMBODIMENT 4

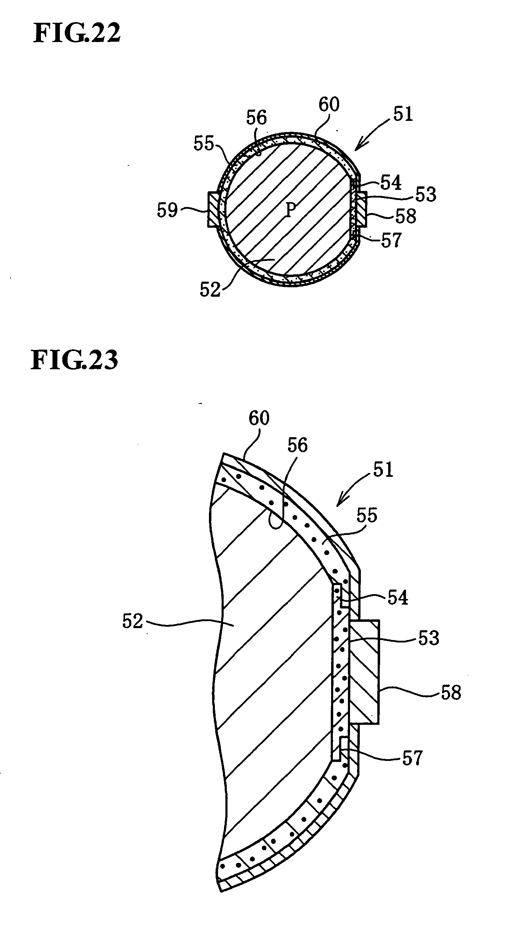

Next, a description is given of the constitution of the solar cell 51 of Embodiment 4.
As shown in Fig. 21 ∼ Fig. 23, solar cell 51 comprises a rod-shaped solar cell having a nearly circular section.

First, a description will be given regarding the constitution of the solar cell 51. As shown in Fig. 21 through Fig. 23, solar cell 51 comprises a rod-shaped p-type silicon monocrystal 52 (this corresponds to the semiconductor substrate), a flat surface 53 formed along the full length at one end in the direction at right angles to the axis of the silicon monocrystal 52, an n⁺ diffusion layer 55 in a partially cylindrical shape formed on the surface area of the silicon monocrystal 52 other than the flat surface 53, a p⁺ diffusion layer 54 formed on the inner surface portion of the flat surface 53 on the silicon monocrystal 52 side, and an anti-reflection film 60 that covers the portions other than the positive electrode 58 and negative electrode 59 within the surface of the solar cell 51. In addition, the positive electrode 58 is equipped on the flat surface 53.

The partially cylindrically shaped pn⁺ junction 56 is formed on the surface of the silicon monocrystal 52 and the pair of electrodes 58, 59 that extend in the lengthwise direction of the silicon monocrystal 52 are connected to the both ends of the pn⁺ junction 56. The p⁺n⁺ junction 57 is formed at both ends in the width direction of the p⁺ diffusion layer 54.
The rod-shaped solar cell 51 has a wide angle light receiving sensitivity because it has near symmetry with the shaft center and has the ability to receive sunlight from various directions. Moreover, a diameter of 1.8 mm or below is preferable for the p-type silicon monocrystal 52, and a length that is equal to or greater than two times of the diameter thereof is preferable for the p-type silicon monocrystal 52, and the width of the flat surface 53 is preferred to be 0.8 mm or less, and the width of the electrodes 58, 59 are preferred to be 0.4 ∼ 0.6 mm. In addition, the flat surface 53 formed on solar cell 51 is not essential and can be omissible.

A description will be given here of a partially modified example of the embodiment.
[1] Instead of utilizing reverse conductivity properties due to the tunneling effects of p⁺n⁺ junctions 7, 17, 20, and 37, a p⁺n⁺ junction can also be formed having low voltage breakdown properties for an avalanche type of increase in reverse current at low voltage equal to or below the open circuit voltage of the pn⁺ junction 6, 16, and 36 arranged in parallel to the p⁺n⁺ junction 7, 17, 20, 37. With this, power loss at the time of reverse bias can be reduced because the breakdown voltage is small, and the primary cause of breakage and deterioration in the solar cell 1, 11, 31, and the module due to heat can be avoided.

[2] The semiconductor substrate may also be a polycrystal.
[3] In addition to adopting an n-type semiconductor substrate instead of the p-type semiconductor substrate, a p⁺n junction may also be formed instead of the pn⁺ junction with a structure that replaces p-type and n-type respectfully in the embodiments.
[4] Instead of a semiconductor substrate composed of silicon, a III-V group such as Ge, GaAs, InP, GaN or a I-III-VI₂ compound semiconductor structure such as CIS or CIGS may also be used.
[5] The introduction of impurities with an ion implantation method may also be used instead of introducing impurities with thermal diffusion.
[6] For the solar cells 1, 12 of embodiments 1, 2, the silicon monocrystals 2, 13 with diameters of 1.8mm or below and the flat surfaces 3, 14 with diameters of 0.8 mm or below are preferable; and the electrodes 8, 9, 19, and 22 with diameters of 0.8mm or below smaller than diameters of the flat surfaces 3, 14 are preferred.

### INDUSTRIAL APPLICABILITY

In addition to preventing heat generation and deterioration of the solar cell when any of the solar cells enter shade with a solar cell module having a plurality of solar cells, the reduction in power generation efficiency in the entire solar cell module can also be prevented by providing a solar cell having reverse conductivity properties when biased in the reverse direction.

## Claims

1. A solar cell equipped with a pn junction capable of generating photovoltaic power on a semiconductor substrate, comprising;
a p⁺n⁺ junction comprising a p⁺ type conductive layer and an n⁺ type conductive layer in which impurities are doped in a high concentration on a portion of the pn junction, and
a structure having a reverse conductivity characteristic for current flow through the p⁺n⁺ junction when the solar cell is biased in a reverse direction.

2. The solar cell according to claim 1, wherein the pn junction is a pn⁺ junction or a p⁺n junction.

3. The solar cell according to claim 1, wherein the p⁺n⁺ junction has backward diode properties due to a tunneling effect.

4. The solar cell according to claim 1, wherein the p⁺n⁺ junction has properties of conducting at an equal to or lower voltage than an open circuit voltage of the pn junction.

5. The solar cell according to claim 1, wherein the semiconductor substrate is formed spherically and comprising a substantially spherical surface shaped pn junction positioned at a constant depth from the surface of the semiconductor substrate, and
comprising a pair of electrodes connected on both ends of the pn junction which are a pair of opposing electrodes interposing a center of the semiconductor substrate.

6. The solar cell according to claim 5, wherein the p⁺n⁺ junction is provided at a nearer portion to a semiconductor substrate side than one of the electrodes within the peripheral vicinity of said one of the electrodes.

7. The solar cell according to claim 5, wherein the pn junction is formed through a n⁺ type conductive layer formed on a surface of the semiconductor substrate in which at least one part of the p⁺n⁺ junction is composed by a p⁺ type conductive layer formed on an inner surface of a semiconductor substrate side of one of the electrodes, and an n⁺ type conductive layer part that is contacted by the p⁺ type conductive layer.

8. The solar cell according to claim 6, wherein the electrode is formed so as to have a larger area than the p⁺n⁺ junction.

9. The solar cell according to claim 7, wherein at least one part of the p⁺n⁺ junction is composed by an n⁺ type conductive layer part that is coupled to the other electrode and a p⁺ type conductive layer that is coupled to the n⁺ type conductive layer part.

10. The solar cell according to any of claims 1 ∼ 4, wherein the semiconductor substrate is formed in a cylindrical shape and which comprises a substantially cylindrical shaped pn junction in a position of constant depth from a surface of the semiconductor substrate.

11. The solar cell according to claim 7, wherein the p⁺ type conductive layer formed on the inner surface of one of the electrodes is formed by way of a recrystallized layer that is formed by an eutectic reaction of the semiconductor substrate with the other metallic electrode.

12. The solar cell according to any one of claims 1 ∼ 4, wherein the semiconductor substrate is formed to be a flat shaped substrate ; and the pn junction is formed on a near area of one surface of a solar light incidence side of the semiconductor substrate; and a grid shaped electrode is provided on a reverse surface to said one surface of the semiconductor substrate; and light receiving windows, which are not shielded by the grid shaped electrode, are formed on said one surface of the semiconductor substrate; and
a high density conductive layer is formed in which impurities are doped in a high concentration with the same electric conductive type as the semiconductor substrate on all surfaces that do not face the light receiving windows on the semiconductor substrate; and
the p⁺n⁺ junction is formed through the high density conductive layer on a rear surface side part of the grid shaped electrode on said one surface of the semiconductor substrate.
